# DEMANDE DE BREVET EUROPEEN

(11) **EP 4 819 787 A1**
(43) Date de publication de la demande: **07.10.2026**
(21) Numéro de dépôt: 26166270.4
(22) Date de dépôt: 20.03.2026
(51) Int. Cl.: H10B 41/30, H10D 30/68, H10D 30/01

(54) **DISPOSITIF ELECTRONIQUE**

(30) Priorité: 31.03.2025 FR 2503303
(71) Demandeur: Centre National de la Recherche Scientifique, 75016 Paris (FR); STMicroelectronics International N.V., 1228 Plan-les-Ouates, Geneva (CH); Université d'Aix Marseille, 13007 Marseille (FR)
(72) Inventeur: DELALLEAU, Julien, 83740 LA CADIERE D'AZUR (FR); AKBAL, Madjid, 13530 TRETS (FR); ALKEMA, Khaled, 13003 MARSEILLE (FR)
(74) Mandataire: Cabinet Beaumont

(57) **Abrégé**

La présente description concerne un dispositif comprenant au moins une cellule mémoire, la cellule mémoire comprenant :
- une zone active (20b), en un matériau semiconducteur, comprenant des régions de source et de drain (22);
- une première grille de sélection (26) en un matériau semiconducteur s'étendant de manière parallèle à la zone active (20b), la première grille de sélection étant séparée de la zone active par une première couche en un matériau diélectrique (28) ; et
- une deuxième grille de mesure (30a, 30b) reposant sur les régions de source et de drain et sur la première grille.

## Description

### Domaine technique

La présente description concerne de façon générale les dispositifs électroniques et leurs procédés de fabrication et en particulier les dispositifs comprenant une mémoire et leurs procédés de fabrication.

### Technique antérieure

Il existe de nombreux types de cellules mémoire. Parmi ces différents types de cellules mémoire, il existe des cellules mémoire dites EEPROM (Electrically-Erasable Programmable Read-Only Memory - mémoire morte effaçable électriquement et programmable). Une cellule mémoire de type EEPROM est un type de mémoire non volatile.

### Résumé de l'invention

Un mode de réalisation prévoit un dispositif comprenant au moins une cellule mémoire, la cellule mémoire comprenant : - une zone active, en un matériau semiconducteur, comprenant des régions de source et de drain ; - une première grille de sélection en un matériau semiconducteur s'étendant de manière parallèle à la zone active, la première grille de sélection étant séparée de la zone active par une première couche en un matériau diélectrique ; et - une deuxième grille de mesure reposant sur les régions de source et de drain et sur la première grille.

Un autre mode de réalisation prévoit un procédé de fabrication d'un dispositif comprenant au moins une cellule mémoire, le procédé comprenant : - la formation d'une zone active, en un matériau semiconducteur, comprenant des régions de source et de drain ; - la formation d'une première grille de sélection en un matériau semiconducteur s'étendant de manière parallèle à la zone active, la première grille de sélection étant séparée de la zone active par une première couche en un matériau diélectrique ; et - la formation d'une deuxième grille de mesure reposant sur les régions de source et de drain et sur la première grille de sélection.

Selon un mode de réalisation, la première grille de sélection est en silicium polycristallin.

Selon un mode de réalisation, la deuxième grille de mesure comprend une deuxième couche en un matériau diélectrique, une première couche en un matériau semiconducteur, une troisième couche en un matériau isolant, et une deuxième couche en un matériau semiconducteur.

Selon un mode de réalisation, la première grille de sélection et la zone active sont séparés uniquement par la première couche en un matériau diélectrique.

Selon un mode de réalisation, la deuxième couche en un matériau diélectrique est en contact avec la première grille de sélection et avec la zone active.

Selon un mode de réalisation, les cellules mémoire sont agencées en une matrice de lignes et colonnes.

Selon un mode de réalisation, la deuxième couche semiconductrice est commune à plusieurs cellules mémoire d'une même ligne.

Selon un mode de réalisation, la première grille de sélection est commune à plusieurs cellules mémoire d'une même colonne.

Selon un mode de réalisation, le dispositif comprend au moins deux cellules mémoire ayant une région de source ou de drain en commun.

Selon un mode de réalisation, le procédé comprend la formation d'une cavité à l'emplacement de la première grille de sélection et la formation de la première couche en un matériau diélectrique le long des parois latérales et du fond de la cavité par oxydation.

Selon un mode de réalisation, des tensions sont appliquées à la cellule mémoire de telle manière que des électrons soient transférés, par effet tunnel Fowler-Nordheim, de la deuxième grille à la première grille de sélection.

Selon un mode de réalisation, des tensions sont appliquées à la cellule mémoire de telle manière que des électrons soient transférés, par effet tunnel Fowler-Nordheim, de la première grille de sélection à la deuxième grille de mesure.

Selon un mode de réalisation, des tensions sont appliquées à la cellule mémoire de telle manière qu'un courant soit formé entre les régions de source et de drain de la cellule.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un mode de réalisation d'un dispositif comprenant une mémoire ;
la figure 2 représente une vue en trois dimensions du mode de réalisation de la figure 1 ;
la figure 3 représente un mode de fonctionnement du dispositif des figures 1 et 2 ;
la figure 4, la figure 5, la figure 6, la figure 7, la figure 8, la figure 9, la figure 10 représentent un mode de réalisation d'un procédé de fabrication du dispositif des figures 1 et 2 ; et
la figure 11 représente une variante du mode de réalisation des figures 1 et 2.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

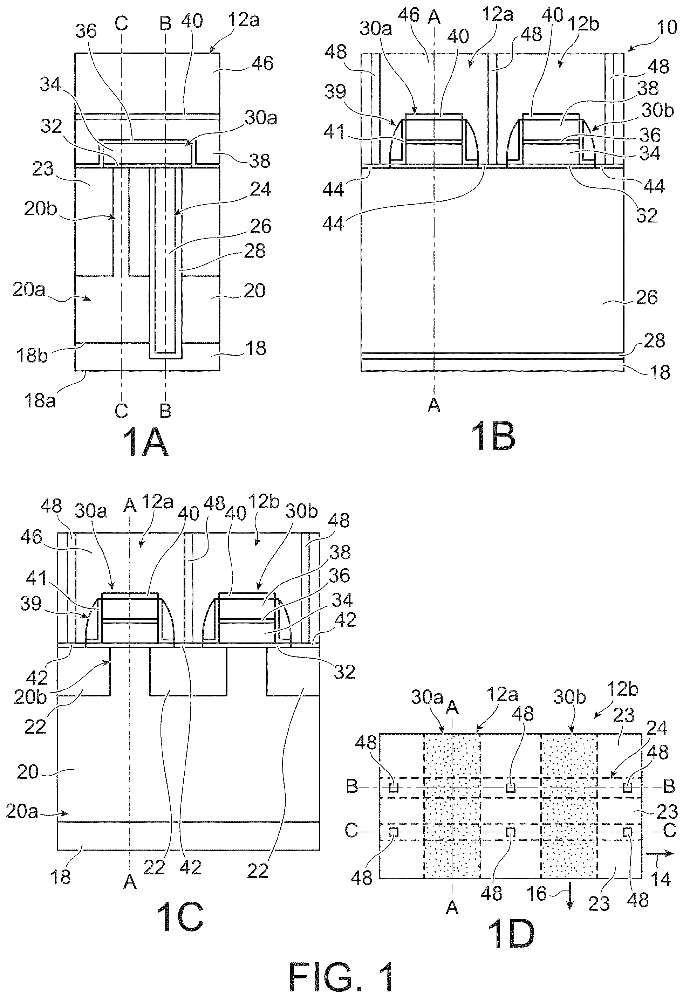

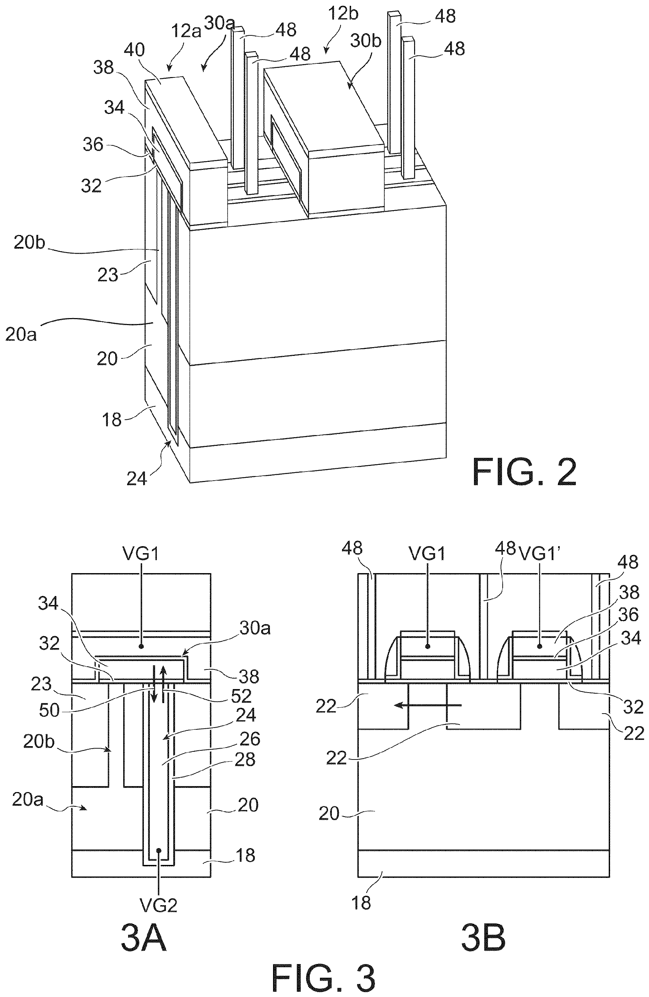

La figure 1 représente un mode de réalisation d'un dispositif 10 comprenant une mémoire. Plus précisément, la figure 1 comprend trois vues en coupe 1A, 1B, 1C du dispositif 10, respectivement selon des plans A-A, B-B, C-C, une vue de dessus 1D et une vue en trois dimensions 1E. Les plans B-B et C-C sont parallèles entre eux. Le plan A-A est perpendiculaire aux plans B-B et C-C. Des éléments de la vue 1D, représentés en pointillés, correspondent à des éléments situés dans les autres plans. La figure 2 représente une vue en trois dimensions du mode de réalisation de la figure 1.

Les figures 1 et 2 représente un ensemble de deux cellules mémoire 12a et 12b. Chaque cellule mémoire 12a ou 12b peut contenir une donnée. Le dispositif 10 comprend de préférence une région de mémoire comprenant une pluralité d'ensembles tel que celui représenté en figures 1 et 2. Par exemple, la région de mémoire comprend une matrice de cellules mémoire 12a, 12b, de préférence uniquement des cellules mémoire 12a, 12b, formant des lignes et des colonnes.

De préférence, les cellules 12a, 12b d'un même ensemble sont alignées dans une première direction, correspondant à une direction orthogonale au plan de la vue 1A. La première direction est dans les plans des vues 1B et 1C. Plus précisément, la première direction correspond à la direction horizontale des vues 1B et 1C. La première direction est représentée par une flèche 14, en vue 1D. La première direction correspond par exemple à la direction des lignes de la matrice de cellules mémoires.

Une deuxième direction correspond par exemple à la direction des colonnes de matrice de cellules mémoires. La deuxième direction est représentée par une flèche 16 en vue 1D. La deuxième direction est perpendiculaire à la première direction dans le plan de la vue 1D.

De préférence, la première direction correspond à la ligne de bit et la deuxième direction correspond à la ligne de mot.

Le dispositif 10 comprend un support 18. Le support 18 est par exemple un substrat semiconducteur. Le support 18 est par exemple en silicium, par exemple en silicium non dopé ou en silicium dopé P. Le support 18 comprend une face inférieure 18a et une face supérieure 18b.

Le dispositif 10 comprend en outre une région 20. La région 20 est une région semiconductrice. La région 20 est par exemple en silicium. La région 20 est par exemple dopée de type P. La région 20 est par exemple une région dopée du support 18. La région 20 repose sur le support 18, plus précisément sur la face supérieure du support 18. La région 20 comprend une partie inférieure 20a et une partie supérieure 20b.

La partie inférieure 20a s'étend, et est de préférence en contact avec, le support 18. La partie 20a a par exemple des faces supérieure et inférieure parallèles entre elles et planes. La partie inférieure 20a est de préférence commune à toutes les cellules mémoire 12a, 12b. La partie supérieure 20b s'étend depuis, et est en contact avec, la face supérieure de la partie 20a. La partie 20b forme un mur s'étendant dans la première direction.

Les parties 20a et 20b sont en le même matériau, dopées du même type. De préférence, les parties 20a et 20b sont dopées par les mêmes dopants. De préférence, la concentration de dopants de la partie 20a est sensiblement égale à la concentration de dopants de la partie 20b.

Le dispositif comprend des régions 22. Plus précisément, chaque ensemble de cellules 12a, 12b comprend trois régions 22. Les régions 22 sont en un matériau semiconducteur, de préférence en le même matériau que la région 20, par exemple en silicium. Les régions 22 sont dopées du type de conductivité opposé au type de conductivité de la région 20. Par exemple, les régions 22 sont dopées de type N. Par exemple, les régions 22 sont des parties dopées du support 18, par exemple des régions dopées de la région 20.

Les régions 22 sont situées dans la partie supérieure de la région 20. Plus précisément, les régions 22 sont situées au niveau de la face supérieure de la partie supérieure 20b de la région 20. Ainsi, les faces supérieures des régions 22 et de la partie supérieure de la région 20 sont coplanaires. Les régions 22 sont séparées les unes des autres par des portions de la région 20. Les régions 22 sont alignées dans la première direction. Ainsi, une des trois régions 22 est située entre les deux autres régions 22 de l'ensemble. Les trois régions 22 de l'ensemble illustré en figures 1 et 2 peuvent ainsi être observées en vue 1C.

La partie 20b est entourée par une couche 23 en un matériau diélectrique, par exemple en oxyde de silicium. Plus précisément, les parois latérales de la partie 20b sont recouvertes par la couche 23. La face inférieure de la partie 20b est en contact avec la partie 20a. la face supérieure de la partie 20b est coplanaire avec la face supérieure de la couche 23.

L'ensemble des cellules 12a, 12b comprend en outre une tranchée 24. La tranchée 24 comprend un cœur 26, par exemple en un matériau semiconducteur, par exemple en silicium polycristallin, et une gaine 28 en un matériau diélectrique. La gaine 28 recouvre de préférence la face inférieure et les faces latérales du cœur 26.

La tranchée 24 s'étend par exemple de la face supérieure de la couche 23 à un niveau situé dans le support 18. La tranchée 24 s'étend dans la couche 23. La tranchée 24 traverse ainsi la couche 23, la partie inférieure 20a et s'étend par exemple dans une partie du support 18. La tranchée 24 s'étend par exemple sur une hauteur supérieure à la hauteur de la région 20.

La tranchée 24 s'étend parallèlement à la partie 20b. Ainsi, la tranchée 24 ne traverse pas, et n'est pas en contact avec la partie 20b. La tranchée 24, et en particulier la gaine 28, est séparée de la partie 20b par une portion de la couche 23. La tranchée 24 est par exemple commune à tous les ensembles de cellules mémoire de la même ligne, c'est-à-dire associés à la même ligne de bit.

Chaque cellule mémoire 12a, 12b comprend une grille 30a, 30b. Plus précisément, la cellule mémoire 12a comprend une grille 30a et la cellule mémoire 12b comprend une grille 30b. Chaque grille 30a, 30b comprend un empilement de couches 32, 34, 36, 38. De préférence, les grilles des cellules mémoire 12a et 12b sont en les mêmes matériaux. Ainsi, les couches 32, 34, 36, 38 de la cellule 12a sont en les mêmes matériaux que les couches 32, 34, 36, 38 de la cellule 12b.

La couche 32 de chaque grille 30a, 30b est en un matériau diélectrique, par exemple en oxyde de silicium. La couche 32 constitue un isolant de grille. La couche 32 s'étend sur, et est de préférence en contact avec, la face supérieure de la partie 20b, de la tranchée 24 et de la couche 23. Plus précisément, la couche 32 recouvre partiellement deux des régions 22 de l'ensemble de cellules 12a, 12b, et la portion de la couche 23 situées entre lesdites régions 22. De préférence, parmi les trois régions 22 de chaque ensemble de cellules 12a, 12b, deux des régions 22 sont partiellement recouvertes par une seule des deux grilles, et la régions 22 situées entre lesdites deux régions est partiellement recouverte par les deux grilles 30a, 30b. La couche 32 recouvre en outre une portion de la tranchée 24 et la portion de la couche 23 située entre ladite portion de la tranchée 24 et les régions 22.

Chaque couche 32 est de préférence spécifique à une seule cellule 12a, 12b. Ainsi, chaque cellule 12a ou 12b de chaque ensemble de cellules 12a, 12b comprend de préférence une couche 32 séparée des autres couches 32.

La couche 34 de chaque grille 30a, 30b est en un matériau semiconducteur, par exemple en silicium polycristallin. La couche 34 s'étend sur, et est de préférence en contact avec, la couche 32. De préférence, la couche 34 s'étend uniquement sur la couche 32. La couche 34 constitue une grille flottante. Par exemple, dans le plan de la vue 1A, c'est-à-dire dans la deuxième direction 16, les dimensions de la couches 34 sont sensiblement égales aux dimensions de la couche 32. Par exemple, dans le plan de la vue 1B ou de la vue 1C, c'est-à-dire dans la première direction 14, les dimensions de la couches 34 sont inférieures aux dimensions de la couche 32.

Chaque couche 34 est de préférence spécifique à une seule cellule 12a, 12b. Ainsi, chaque cellule 12a ou 12b de chaque ensemble de cellules 12a, 12b comprend de préférence une couche 34 séparée des autres couches 34.

La couche 36 de chaque grille 30a, 30b est par exemple en un matériau diélectrique, par exemple en oxyde de silicium ou en un empilement de couches en des matériaux diélectriques, par exemple un empilement d'une couche en oxyde de silicium, une couche en nitrure de silicium et une couche en oxyde de silicium. La couche 36 constitue un isolant de grille. La couche 36 s'étend sur, et est de préférence en contact avec, la face supérieure de la couche 34. Par exemple, dans le plan de la vue 1B ou de la vue 1C, c'est-à-dire dans la première direction 14, les dimensions de la couches 36 sont sensiblement égales aux dimensions de la couche 34 c'est-à-dire égales aux dimensions de la couche 32. Par exemple, dans le plan de la vue 1A, c'est-à-dire dans la deuxième direction 16, les dimensions de la couches 36 sont supérieures aux dimensions de la couche 32. De préférence, dans le plan de la vue 1A, la couche 36 s'étend sur, et est de préférence en contact avec, les parois latérales des couches 32 et 34 et la face supérieure des portions de la couche 23 situées entre les grilles des cellules des différentes lignes de bits.

Chaque couche 36 est par exemple commune à plusieurs grilles, de préférence commune à plusieurs grilles d'une même ligne de mots. Ainsi, les couches 36 des cellules d'une ligne de mot, s'étendant dans la deuxième direction 16, comprennent de préférence une même couche 36. Les couches 36 des cellules d'une même ligne de bits sont de préférence séparées les unes des autres. En particulier, les couches 36 des grilles 30a, 30b d'un ensemble de cellules 12a, 12b sont distinctes et séparées l'une de l'autre.

La couche 38 de chaque grille 30a, 30b est en un matériau conducteur ou semiconducteur, par exemple en silicium polycristallin. La couche 38 constitue une grille de contact. La couche 38 s'étend sur, et est de préférence en contact avec, la face supérieure de la couche 36. Par exemple, dans le plan de la vue 1B ou de la vue 1C, c'est-à-dire dans la première direction 14, les dimensions de la couches 38 sont sensiblement égales aux dimensions de la couche 36, c'est-à-dire égales aux dimensions de la couche 32. Par exemple, dans le plan de la vue 1A, c'est-à-dire dans la deuxième direction 16, les dimensions de la couches 38 sont supérieures aux dimensions de la couche 32. De préférence, dans le plan de la vue 1A, la couche 38 s'étend sur, et est de préférence en contact avec, la face supérieure de la couche 36, de préférence toute la face supérieure de la couche 36.

Chaque couche 38 est par exemple commune à plusieurs grilles, de préférence commune à plusieurs grilles d'une même ligne de mots. Ainsi, les couches 38 des cellules d'une ligne de mot, s'étendant dans la deuxième direction 16, comprennent de préférence une même couche 38. Les couches 38 des cellules d'une même ligne de bits sont de préférence séparées les unes des autres. En particulier, les couches 38 des grilles 30a, 30b d'un ensemble de cellules 12a, 12b sont distinctes et séparées l'une de l'autre.

Chaque cellule 12a, 12b comprend par exemple des espaceurs 39 et des couches 41 en un matériau diélectrique recouvrant une partie de la face supérieure de la couche 32 et les parois latérales des couches 34, 36, 38 s'étendant dans des plans parallèles au plan de la vue 1A.

Chaque cellule 12a, 12b comprend par exemple une couche 40 de siliciure métallique. La couche 40 de chaque cellule repose sur, et est de préférence en contact avec, la face supérieure de la couche 38. Chaque couche 40 est de préférence située en regard des couches 30 et 32 de la cellule 12a, 12b.

Chaque ensemble de deux cellules 12a et 12b comprend en outre trois couches 42 de siliciure métallique et au moins une couche 44 de siliciure métallique. En figures 1 et 2, le mode de réalisation comprend trois couches 44. Les couches 42 et 44 sont par exemple en le même matériau que les couches 40. Chaque couche 42 repose sur, et est de préférence en contact avec, une région 22. Ainsi, chaque région 22 est partiellement recouverte par une couche 42. Les couches 44 repose sur, et sont de préférence en contact avec le cœur 26 de la tranchée 24.

Le dispositif comprend en outre une couche 46 en un matériau isolant, par exemple en oxyde de silicium. La couche 46 recouvre la structure du dispositif. En particulier, la couche 46 recouvre les cellules 12a, 12b, de préférence toutes les cellules 12a, 12b, et en particulier les grilles 30a, 30b de toutes les cellules 12a, 12b.

Le dispositif comprend en outre des vias conducteurs 48. Les vias 48 sont en un matériau conducteur, par exemple en métal. Les vias 48 traversent la couche 46 de manière à atteindre les couches 42 et 44. Le dispositif comprend par exemple des vias non représentés, par exemple identiques aux vias 48, traversant la couche 46 de manière à atteindre les couches 40.

Les régions 22 forment ainsi des régions de source et de drain et peuvent être polarisées dans des étapes de programmation des cellules mémoire. De même, le cœur 26 de la tranchée 24 forme une grille arrière commune aux cellules 12a, 12b de l'ensemble, et peut être polarisée dans des étapes de programmation des cellules mémoire. Les couches 38 forment des grilles avant et peuvent être polarisées dans des étapes de programmation des cellules mémoire.

La figure 3 représente un mode de fonctionnement du dispositif des figures 1 et 2. Plus précisément, la figure 3 comprend une vue 3A illustrant des étapes d'écriture et d'effacement d'une donnée dans une cellule mémoire telle que celles représentées en figure 1 et comprend une vue 3B illustrant une étape de lecture des cellules mémoire.

La vue 3A est une vue en coupe du dispositif 10 de la figure 1 selon le plan de coupe de la vue 1A. La vue 2A comprend une flèche 50 allant de la couche 34 vers le cœur 26 d'une cellule mémoire 12a ou 12b et illustrant une étape d'écriture d'une donnée dans ladite cellule 12a, 12b. La vue 3A comprend une flèche 52 allant du cœur 26 vers la couche 34 d'une cellule mémoire 12a ou 12b et illustrant une étape d'effacement d'une donnée dans ladite cellule 12a, 12b.

Au cours de l'étape d'écriture d'une cellule mémoire 12a, 12b, des tensions sont appliquées à ladite cellule mémoire de manière à ce que des électrons soient transférés, par effet tunnel Fowler-Nordheim, de la couche 34 au cœur 26 où ils sont stockés.

Une tension VG1 est appliquée à la grille avant de la cellule dans laquelle est écrite la donnée au cours de cette étape. Autrement dit, la tension VG1 est appliquée à la couche 38 de la grille 30a ou 30b de la cellule mémoire 12a, 12b dans laquelle est écrite la donnée au cours de cette étape. De même, une tension VG2 est appliquée à la grille avant de la cellule dans laquelle est écrite la donnée au cours de cette étape. Autrement dit, la tension VG2 est appliquée au cœur 26 de la tranchée 24 de la cellule mémoire 12a, 12b dans laquelle est écrite la donnée au cours de cette étape. En outre, une tension VG1' est appliquée à la grille avant de l'autre cellule mémoire de l'ensemble de cellules 12a, 12b.

Les tensions VG1 et VG1' sont par exemple, au cours de l'étape d'écriture, des valeurs négatives. Au cours de l'étape d'écriture, la valeur de la tension VG1' est par exemple supérieure à la valeur de la tension VG1. Par exemple, la tension VG1' au cours de l'étape d'écriture est par exemple comprise entre -5 V et -1 V, par exemple sensiblement égale à -1,4 V. Par exemple, la tension VG1 au cours de l'étape d'écriture est par exemple comprise entre -10 V et -5 V, par exemple sensiblement égale à -8 V.

La valeur de la tension VG2 est, au cours de l'étape d'écriture, par exemple positive. La valeur de la tension VG2 est, au cours de l'étape d'écriture, supérieure aux tensions VG1 et VG1'. La valeur de la tension VG2 est, au cours de l'étape d'écriture, par exemple sensiblement égale à l'opposé de la valeur de la tension VG1. La valeur de la tension VG2 est, au cours de l'étape d'écriture, par exemple comprise entre 5 V et 10 V, par exemple sensiblement égale à 8 V.

De préférence, au cours de l'étape d'écriture, les régions 22 des cellules dudit ensemble ne sont pas polarisées, c'est-à-dire sont flottantes, ou sont polarisée à la tension de référence, par exemple la masse.

Les différentes tensions sont appliquées par l'intermédiaire des vias 48 non représenté en vue 3A.

Au cours de l'étape d'effacement d'une cellule mémoire 12a, 12b, des tensions sont appliquées à ladite cellule mémoire de manière à ce que des électrons soient transférés, par effet tunnel Fowler-Nordheim, du cœur 26, où ils étaient stockés, à la couche 34.

Comme durant l'étape d'écriture, une tension VG1 est appliquée à la grille avant de la cellule dans laquelle est effacée la donnée au cours de cette étape. Autrement dit, la tension VG1 est appliquée à la couche 38 de la grille 30a ou 30b de la cellule mémoire 12a, 12b dans laquelle est effacée la donnée au cours de cette étape. De même, une tension VG2 est appliquée à la grille avant de la cellule dans laquelle est effacée la donnée au cours de cette étape. Autrement dit, la tension VG2 est appliquée au cœur 26 de la tranchée 24 de la cellule mémoire 12a, 12b dans laquelle est effacée la donnée au cours de cette étape.

La tension VG1 a par exemple, au cours de l'étape d'effacement, une valeur positive. Par exemple, la tension VG1 au cours de l'étape d'effacement est par exemple comprise entre 10 V et 5 V, par exemple sensiblement égale à 8 V.

La valeur de la tension VG2 est, au cours de l'étape d'effacement, par exemple négative. La valeur de la tension VG2 est, au cours de l'étape d'effacement, supérieure à la tension VG1. La valeur de la tension VG2 est, au cours de l'étape d'effacement, par exemple sensiblement égale à l'opposé de la valeur de la tension VG1. La valeur de la tension VG2 est, au cours de l'étape d'effacement, par exemple comprise entre -5 V et -10 V, par exemple sensiblement égale à -8 V.

De préférence, au cours de l'étape d'effacement, les régions 22 des cellules dudit ensemble ainsi que la grille avant de l'autre cellule de l'ensemble ne sont pas polarisées, c'est-à-dire sont flottantes, ou sont polarisée à la tension de référence, par exemple la masse.

Les différentes tensions sont appliquées par l'intermédiaire des vias 48 non représenté en vue 3A.

La vue 3B est une vue en coupe du dispositif 10 de la figure 1 selon le plan de coupe de la vue 1C.

Au cours de l'étape de lecture, un courant est formé entre les régions de source et de drain de la cellule mémoire à lire, c'est-à-dire les régions 22 de la cellule mémoire à lire. La valeur du courant formée dépend de la quantité d'électrons stockés dans la grille flottante 34 et permet ainsi de déterminer l'état de programmation de la cellule.

Par exemple, au cours de l'étape de lecture, la tension VG1 est supérieure à la tension VG1'. Par exemple, au cours de l'étape de lecture, la tension VG1 est positive et la tension VG1' est négative. Par exemple, les tensions VG1 et VG1' sont respectivement sensiblement égales à 2 V et -1 V. En outre, la tension VG2 est de préférence égale à une tension de référence, par exemple la masse au cours de l'étape de lecture. Une tension appliquée à la région 20 est de préférence égale à une tension de référence, par exemple la masse au cours de l'étape de lecture.

Les régions 22 de la cellule à lire sont polarisée de manière à former un courant électrique. Par exemple, l'une des régions 22 est polarisée par une tension positive, par exemple sensiblement égale à 1 V, et l'autre est polarisée par la tension de référence, par exemple la masse.

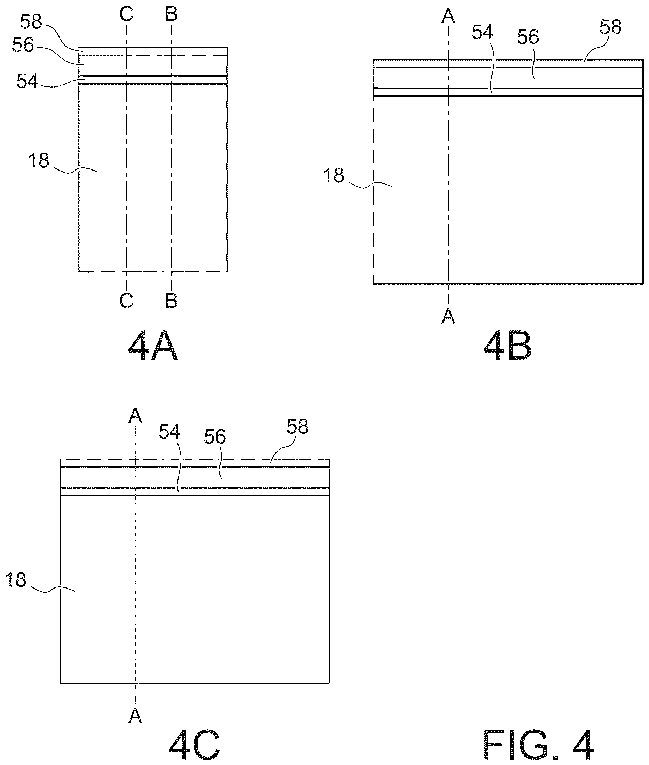

La figure 4, la figure 5, la figure 6, la figure 7, la figure 8, la figure 9, la figure 10 représentent un mode de réalisation d'un procédé de fabrication du dispositif des figures 1 et 2. Plus précisément, les figures 4 à 10 illustrent des structures résultant d'étapes, de préférence successives, d'un procédé de fabrication du dispositif des figures 1 et 2.

La figure 4 représente une structure résultant d'une étape de fabrication du dispositif des figures 1 et 2. La figure 4 comprend des vues en coupe 4A, 4B et 4C, respectivement selon les plans de coupe des vues 1A, 1B et 1C.

Au cours de cette étape, un empilement de couches 54, 56, 58 en des matériaux diélectriques est formé sur une face supérieure du support 18. L'empilement comprend, dans le procédé des figures 4 à 10, trois couches 54, 56, 58. De manière plus générale, l'empilement peut avoir un nombre quelconque de couches.

De préférence, le support 18 est une plaque semiconductrice ("wafer"). Par exemple, le support 18 est en silicium non dopé ou en silicium dopé P.

La couche 54 est la couche de l'empilement la plus proche du support 18. La couche 54 s'étend sur, et est de préférence en contact avec, la face supérieure du support 18, de préférence avec toute la face supérieure du support 18. La couche 54 est par exemple en oxyde de silicium.

La couche 56 s'étend sur, et est de préférence en contact avec, la face supérieure de la couche 54, de préférence avec toute la face supérieure de la couche 54. La couche 56 est en un matériau différent du matériau de la couche 54, par exemple en nitrure de silicium.

La couche 58 s'étend sur, et est de préférence en contact avec, la face supérieure de la couche 56, de préférence avec toute la face supérieure de la couche 56. La couche 58 est en un matériau différent du matériau de la couche 56, par exemple en le matériau de la couche 54, par exemple en oxyde de silicium.

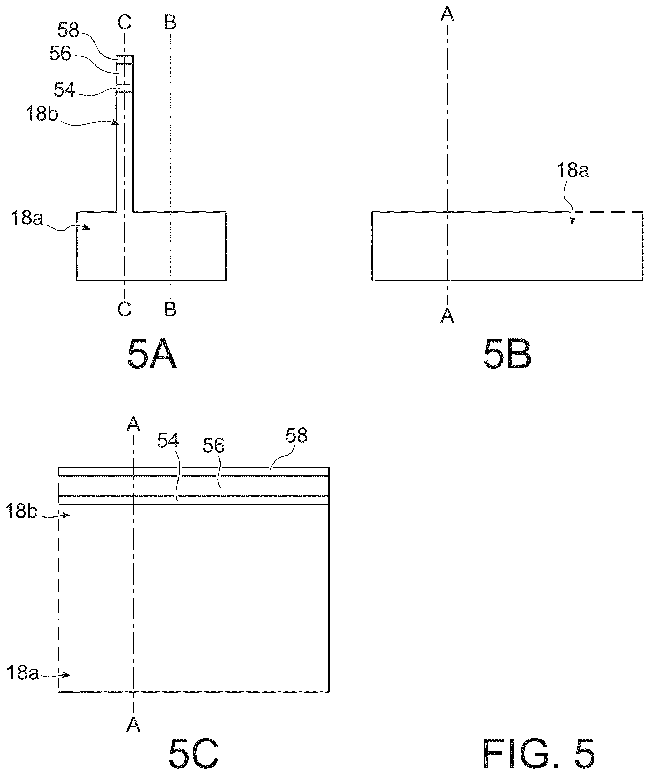

La figure 5 représente une structure résultant d'une étape de fabrication du dispositif des figures 1 et 2. La figure 5 comprend des vues en coupe 5A, 5B et 5C, respectivement selon les plans de coupe des vues 1A, 1B et 1C.

Au cours de cette étape, le support 18 est gravé de manière à former une première portion 18a, correspondant au support 18 de la figure 1 et à la portion 20a de la figure 1, et une deuxième portion 18b, correspondant à la portion 20b de la figure 1 et aux régions 22 de la figure 1.

Plus précisément, l'étape de la figure 5 comprend la formation d'un masque de gravure non représenté recouvrant l'emplacement où sera situé la portion 20b et les régions 22. L'étape de la figure 5 comprend ensuite la gravure de l'empilement des couches 34, 36, 38 et du support 18 autour du masque de gravure de manière à former les portions 18a et 18b. L'étape de la figure 5 comprend en outre le retrait du masque de gravure.

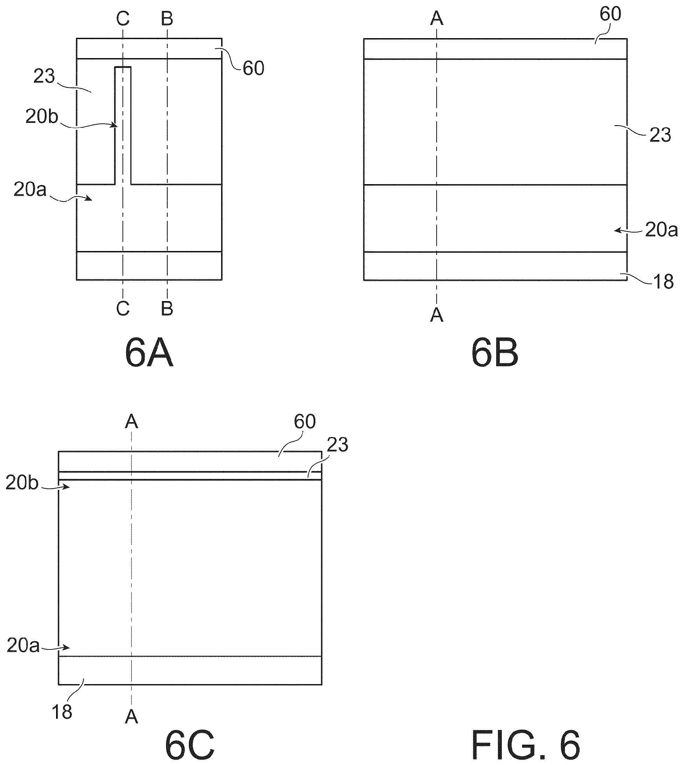

La figure 6 représente une structure résultant d'une étape de fabrication du dispositif des figures 1 et 2. La figure 6 comprend des vues en coupe 6A, 6B et 6C, respectivement selon les plans de coupe des vues 1A, 1B et 1C.

Au cours de cette étape, l'empilement de couches 54, 56, 58 est retiré, par exemple par gravure. En outre, la couche 23 est formée sur la structure. La couche 23 est formée de manière à recouvrir la face supérieure du support 18 et en particulier de manière à s'étendre au moins sur toute la hauteur de la portion 18b. La face supérieure de la couche 23 est par exemple située à un niveau supérieur au niveau de la face supérieure de la portion 18b.

Dans l'exemple de la figure 6, la face supérieure de la couche 23 est plane. Alternativement, la couche 23 peut comprendre une cavité non représentée au-dessus de la portion 18b. La cavité non représentée a de préférence une épaisseur telle que la face supérieure de la portion 18b n'est pas découverte et reste couverte par une portion de la couche 23.

L'étape de la figure 6 comprend en outre la formation, par exemple par dopage, de la région 20. Ainsi, des dopants de type P sont implanté dans le support 18 de manière à former la région 20, c'est-à-dire les portions 20a et 20b.

L'étape de la figure 6 comprend par exemple aussi la formation d'une couche 60 en un matériau diélectrique sur la face supérieure de la structure. Ainsi, la couche 60 s'étend sur, et de préférence en contact avec, la face supérieure de la couche 23. La couche 60 est de préférence en un matériau diélectrique différent du matériau de la couche 23, par exemple en nitrure de silicium.

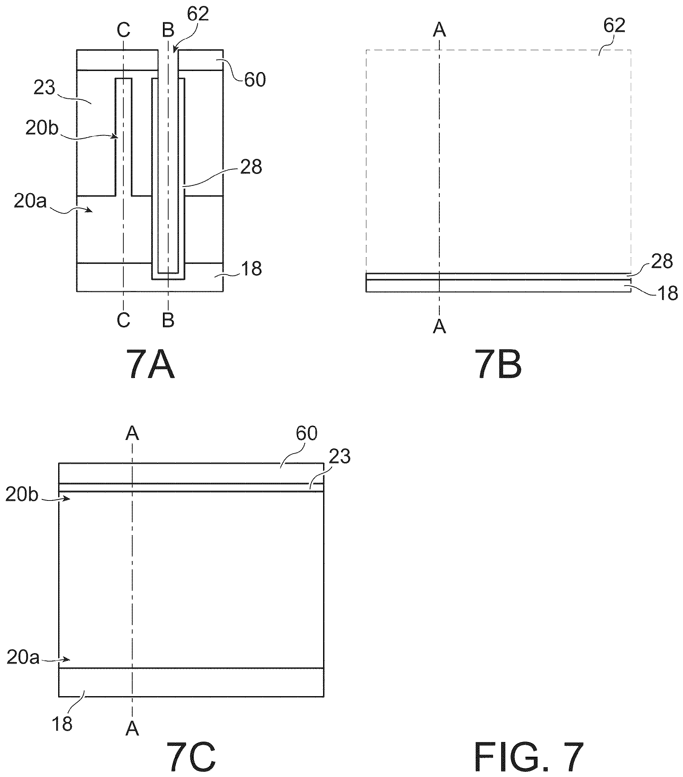

La figure 7 représente une structure résultant d'une étape de fabrication du dispositif des figures 1 et 2. La figure 7 comprend des vues en coupe 7A, 7B et 7C, respectivement selon les plans de coupe des vues 1A, 1B et 1C.

Au cours de cette étape, une cavité 62 est formée dans la structure. La cavité 62 est formée à l'emplacement où sera situé le cœur 26. Plus précisément, l'étape de la figure 7 comprend la formation d'un masque de gravure non représenté comprenant une ouverture située en regard de l'emplacement où sera formé le cœur 26. L'étape de formation de la cavité 62 comprend ensuite la gravure, à travers l'ouverture du masque, des couches 60 et 23, de la portion 20a et du support 18 de manière à former la cavité 62.

Selon le mode de réalisation des figures 4 à 10, la cavité 62 ne traverse pas, et de préférence ne découvre pas, la portion 20b.

L'étape de la figure 7 comprend par exemple le retrait du masque non représenté.

L'étape de la figure 7 comprend en outre la formation de la gaine 28. Plus précisément, l'étape de la figure 6 comprend par exemple une étape d'oxydation des parois, c'est-à-dire les parois latérales et le fond, de la cavité 62.

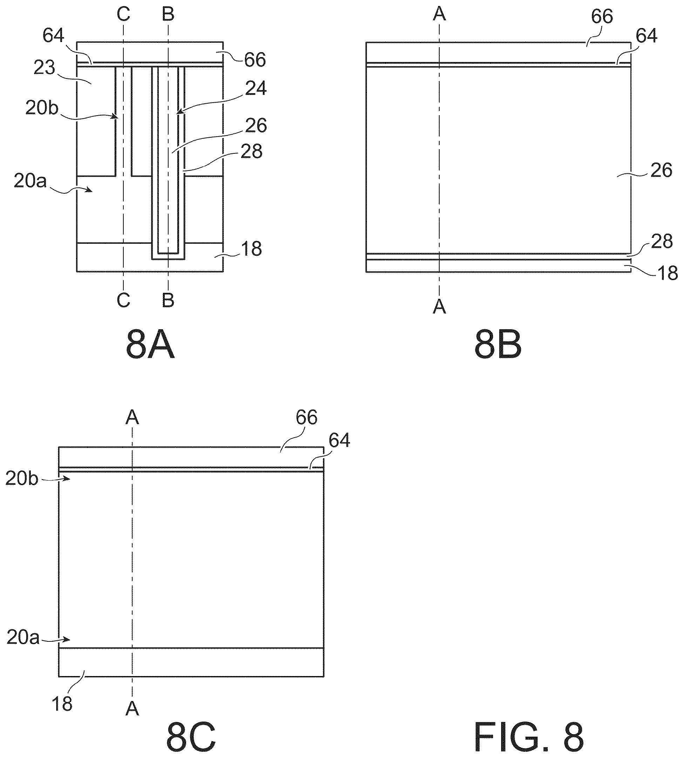

La figure 8 représente une structure résultant d'une étape de fabrication du dispositif des figures 1 et 2. La figure 8 comprend des vues en coupe 8A, 8B et 8C, respectivement selon les plans de coupe des vues 1A, 1B et 1C.

L'étape de la figure 8 comprend la formation du cœur 26 de la tranchée 24. Plus précisément, l'étape de la figure 8 comprend par exemple la formation d'une couche en le matériau du cœur remplissant la cavité 62, par exemple en silicium polycristallin, et recouvrant par exemple l'ensemble de la structure. Ladite couche est par exemple ensuite planarisée de manière à ne conserver que le cœur 26.

L'étape de la figure 8 comprend en outre le retrait de la couche 60. Par exemple, la couche 60 est retirée par l'étape de planarisation permettant le retrait de la couche non représentée en le matériau du cœur 26.

L'étape de la figure 8 comprend la formation d'une couche 64 en le matériau des couches 32, c'est-à-dire en un matériau diélectrique, par exemple en le même matériau que la couche 23. La couche 64 recouvre par exemple la face supérieure de la structure résultant de la formation du cœur 26. Ainsi, la couche 64 repose sur, et est de préférence en contact avec, la face supérieure de la couche 23, de la portion 20b, et de la tranchée 24, c'est-à-dire du cœur 26 et de la gaine 28.

L'étape de la figure 8 comprend la formation d'une couche 66 en le matériau des couches 34, c'est-à-dire en silicium polycristallin. La couche 66 recouvre par exemple la face supérieure de la couche 64, de préférence toute la couche 64. Ainsi, la couche 66 s'étend en regard de la couche 23, de la portion 20b, et de la tranchée 24, c'est-à-dire du cœur 26 et de la gaine 28.

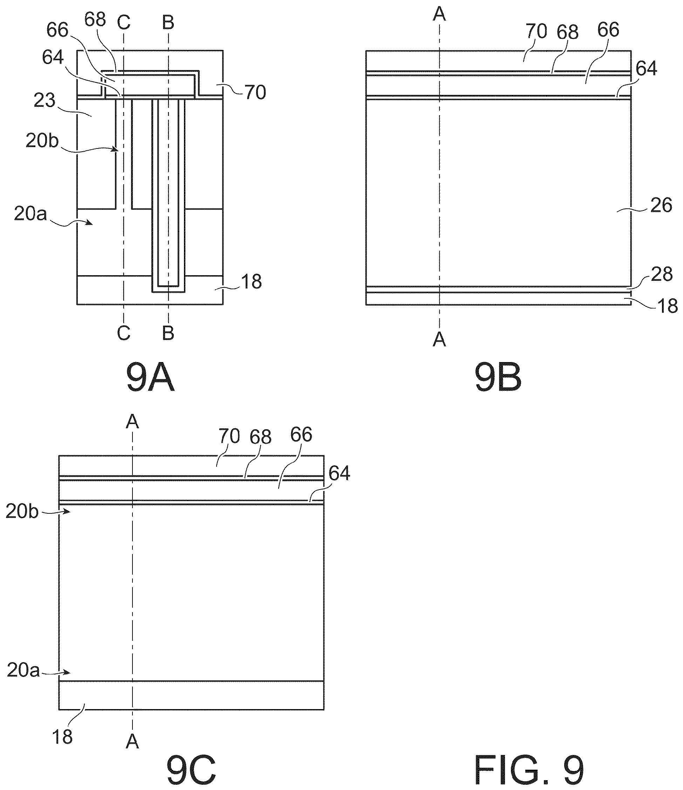

La figure 9 représente une structure résultant d'une étape de fabrication du dispositif des figures 1 et 2. La figure 9 comprend des vues en coupe 9A, 9B et 9C, respectivement selon les plans de coupe des vues 1A, 1B et 1C.

L'étape de la figure 9 comprend la gravure partielle de la couche 66. Plus précisément, la couche 66 est gravée de manière à former des bandes s'étendant dans la première direction, c'est-à-dire la direction des lignes de bit. Le dispositif comprend de préférence une bande par ligne de bit. Chaque bande formée dans la couche 66 comprend ainsi les couches 34 de toutes les grilles de la même ligne de bit. Toutes les cellules sont de préférence recouvertes par une bande formée à partir de la couche 66.

Par exemple, les couches 64 et 66 sont gravées simultanément. Chaque bande comprend alors un empilement d'une bande de la couche 64 et d'une bande de la couche 66 ayant de préférence de mêmes dimensions horizontales.

En outre, l'étape de la figure 9 comprend la formation d'une couche 68 en le matériau des couches 36, c'est-à-dire en un matériau diélectrique, par exemple en le même matériau que la couche 64. La couche 68 recouvre par exemple la face supérieure de la structure résultant de la formation des bandes de la couche 66. Ainsi, la couche 68 repose sur, et est de préférence en contact avec, la face supérieure de la couche 23 et les bandes de couches 64 et 66.

L'étape de la figure 9 comprend la formation d'une couche 70 en le matériau des couches 38, c'est-à-dire en silicium polycristallin. La couche 70 recouvre par exemple la face supérieure de la couche 68, de préférence toute la couche 68.

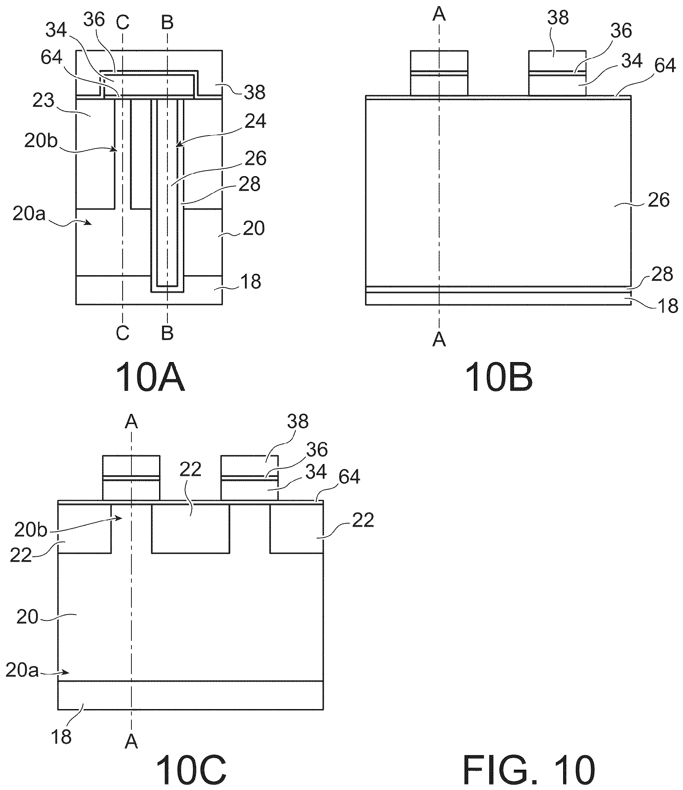

La figure 10 représente une structure résultant d'une étape de fabrication du dispositif des figures 1 et 2. La figure 10 comprend des vues en coupe 10A, 10B et 10C, respectivement selon les plans de coupe des vues 1A, 1B et 1C.

L'étape de la figure 10 comprend la gravure partielle des couches 66, 68 et 70. Plus précisément, l'étape de la figure 10 comprend la formation d'un masque de gravure non représenté. Ledit masque de gravure comprend des bandes s'étendant dans la direction des lignes de mot, c'est-à-dire dans la direction perpendiculaire à la direction des bandes formées dans la couche 66 durant l'étape de la figure 9. Chaque bande du masque de gravure s'étend ainsi en regard de l'emplacement des grilles des cellules mémoire de la même ligne de mot.

Les couches 66, 68 et 70 sont ensuite gravées, de préférence sur toute leur hauteur, autour des bandes du masque de gravure de manière à former les couches 34, 36 et 38.

La couche 64 forme ainsi encore des bandes s'étendant dans la direction des lignes de bit. Les couches 34 de chaque cellule sont séparées les unes des autres, la couche 66 ayant été gravées en bande dans deux directions perpendiculaires. Les couches 36 et 38 forment des bandes dans la direction des lignes de mot.

Le procédé de fabrication du dispositif de la figure 1 comprend en outre des étapes suivant les étapes décrites en relation avec la figure 10. Ainsi, le procédé comprend la formation des espaceurs 39 et de la couche 41, la gravure de la couche 64 de manière à former les couches 32 et de manière à découvrir les régions 22 aux emplacements des couches 44, la formation des couches 44 et 40, la formation de la couche 46 recouvrant l'ensemble de la structure, et la formation des vias conducteurs 48 traversant la couche 46 de manière à atteindre les couches 44 et 40.

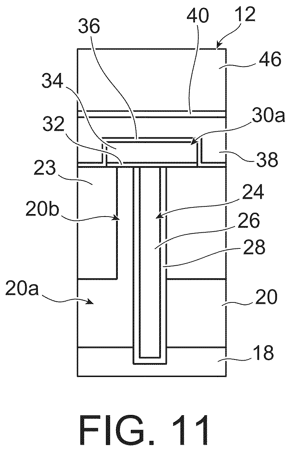

La figure 11 représente une variante du mode de réalisation des figures 1 et 2. Plus précisément, la figure 11 est une vue en coupe d'une variante du mode de réalisation de la figure 1 selon le plan de coupe de la vue 1A.

La figure 11 représente un dispositif 72 comprenant les éléments du dispositif 10 de la figure 1. Le dispositif 72 comprend, comme le dispositif 10 de la figure 1, des ensembles de deux cellules mémoire, par exemple arrangés en matrice dans une région mémoire, bien que la figure 11 ne représente qu'une cellule mémoire de l'ensemble. Le dispositif 72 comprend, comme le dispositif 10 décrit en relation avec figure 1 :
- le support 18,
- la couche 20 comprenant les parties 20a et 20b,
- la couche 23, la tranchée 24 de chaque cellule comprenant le cœur 26 et la gaine 28,
- une grille de chaque cellule, comprenant des couches 32, 34, 36, 38,
- les couches 40 et 44 de saliciure ;
- la couche 46 de protection de la structure, et
- les vias 48.

Le dispositif 72 diffère du dispositif 10 en ce que la tranchée 24 est formée au niveau d'une interface entre la partie 20b et la couche 23. Autrement dit, la tranchée 24 est située entre la partie 20b et la couche 23. Ainsi, le cœur 26 de la tranchée 24 est séparé de la partie 20b uniquement par la gaine 28.

Le procédé de fabrication du dispositif de la figure 11 est identique au procédé décrit en relation avec les figures 4 à 10, à la différence qu'à l'étape de la figure 7, la cavité 62 est situé au niveau de l'interface entre la partie 20b et la couche 23. Ainsi, durant cette étape, les parois de la cavité 62 sont formées par la partie 20b, la couche 23, la partie 20a et le support 18.

Un avantage des modes de réalisation décrits est que les cellules mémoire sont plus compactes et qu'il est ainsi possible de former les cellules de manière plus dense.

Un autre avantage des modes de réalisation décrits est qu'il n'est pas nécessaire de différentier les oxydes de lecture et d'écriture.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif comprenant au moins une cellule mémoire, la cellule mémoire comprenant :
- une zone active (20b), en un matériau semiconducteur, comprenant des régions de source et de drain (22);
- une première grille de sélection (26) en un matériau semiconducteur s'étendant de manière parallèle à la zone active (20b), la première grille de sélection étant séparée de la zone active par une première couche en un matériau diélectrique (28) ; et
- une deuxième grille de mesure (30a, 30b, 32, 34, 36, 38) reposant sur les régions de source et de drain et sur la première grille.

2. Procédé de fabrication d'un dispositif comprenant au moins une cellule mémoire, le procédé comprenant :
- la formation d'une zone active (20b), en un matériau semiconducteur, comprenant des régions (22) de source et de drain;
- la formation d'une première grille de sélection (26) en un matériau semiconducteur s'étendant de manière parallèle à la zone active (20b), la première grille de sélection étant séparée de la zone active par une première couche (28) en un matériau diélectrique ; et
- la formation d'une deuxième grille de mesure (30a, 30b, 32, 34, 36, 38) reposant sur les régions de source et de drain et sur la première grille de sélection (26).

3. Dispositif selon la revendication 1 ou procédé selon la revendication 2, dans lequel les faces supérieures des régions de drain et de source étant coplanaires avec la face supérieure de la zone active (20b) et dans lequel la première grille de sélection est séparée latéralement de la zone active par une première couche en un matériau diélectrique (28).

4. Dispositif selon la revendication 1 ou 3 ou procédé selon la revendication 2 ou 3, dans lequel la première grille de sélection (26) est en silicium polycristallin.

5. Dispositif selon la revendication 1, 3 ou 4 ou procédé selon l'une quelconque des revendications 2 à 4, dans lequel la deuxième grille de mesure (30a, 30b, 32, 34, 36, 38) comprend une deuxième couche (32) en un matériau diélectrique, une première couche (34) en un matériau semiconducteur, une troisième couche (36) en un matériau isolant, et une deuxième couche (38) en un matériau semiconducteur.

6. Dispositif ou procédé selon la revendication 5, dans lequel la deuxième couche (32) en un matériau diélectrique est en contact avec la première grille de sélection (26) et avec la zone active (20b).

7. Dispositif selon la revendication 1, 3 à 6 ou procédé selon l'une quelconque des revendications 2 à 6, dans lequel la première grille de sélection (26) et la zone active (20b) sont séparés uniquement par la première couche (28) en un matériau diélectrique.

8. Dispositif selon l'une quelconque des revendications 1, 3 à 7 ou procédé selon l'une quelconque des revendications 2 à 7, dans lequel les cellules mémoire sont agencées en une matrice de lignes et colonnes.

9. Dispositif ou procédé selon la revendication 8, dans lequel la deuxième couche (38) semiconductrice est commune à plusieurs cellules mémoire d'une même ligne.

10. Dispositif ou procédé selon la revendication 8 ou 9, dans lequel la première grille de sélection (26) est commune à plusieurs cellules mémoire d'une même colonne.

11. Dispositif selon l'une quelconque des revendications 1, 3 à 10 ou procédé selon l'une quelconque des revendications 2 à 10, dans lequel le dispositif comprend au moins deux cellules mémoire (12a, 12b) ayant une région (22) de source ou de drain en commun.

12. Procédé selon l'une quelconque des revendications 2 à 11, dans lequel le procédé comprend la formation d'une cavité (62) à l'emplacement de la première grille de sélection (26) et la formation de la première couche (28) en un matériau diélectrique le long des parois latérales et du fond de la cavité (62) par oxydation.

13. Procédé d'écriture d'une donnée dans une cellule mémoire du dispositif selon l'une quelconque des revendications 5, ou 6 à 11 dans son rattachement à la revendication 5, dans lequel des tensions sont appliquées à la cellule mémoire de telle manière que des électrons soient transférés, par effet tunnel Fowler-Nordheim, de la deuxième grille (34) à la première grille de sélection (26).

14. Procédé d'effacement d'une donnée dans une cellule mémoire du dispositif selon l'une quelconque des revendications 5 ou 6 à 11 dans son rattachement à la revendication 5, dans lequel des tensions sont appliquées à la cellule mémoire de telle manière que des électrons soient transférés, par effet tunnel Fowler-Nordheim, de la première grille de sélection (26) à la deuxième grille de mesure (34).

15. Procédé de lecture d'une donnée dans une cellule mémoire du dispositif selon l'une quelconque des revendications 1, 3 à 11, dans lequel des tensions sont appliquées à la cellule mémoire de telle manière qu'un courant soit formé entre les régions (22) de source et de drain de la cellule.
